# EUROPEAN PATENT SPECIFICATION

(11) **EP 2 195 475 B1**
(45) Date of publication and mention of the grant of the patent: **14.11.2012**
(21) Application number: 08782387.8
(22) Date of filing: 25.07.2008
(51) Int. Cl.: C30B 15/00, C30B 29/06

(54) **WAFER/RIBBON CRYSTAL AND METHOD FOR ITS MANUFACTURE**
WAFER/BANDKRISTALL UND VERFAHREN ZU IHRER HERSTELLUNG
PLAQUETTE/RUBAN DE CRISTAL ET METHODE DE SA FABRICATION

(30) Priority: 27.07.2007 US 952435 P
(43) Date of publication of application: 16.06.2010
(73) Proprietor: Max Era, Inc., Reno, NV 89509-7020 (US)
(72) Inventor: GABOR, Andrew, Providence, RI 02906 (US)
(74) Representative: Körfer, Thomas
(86) International application number: PCT/US2008/071179
(87) International publication number: WO 2009/018145

(56) References cited:
- EP-A- 0 079 567
- JP-A- 62 108 797
- JP-A- 62 123 092
- JP-A- 2001 122 696
- US-A- 4 689 109
- US-A- 5 122 504
- HAHN G ET AL: "14% EFFICIENT LARGE AREA SCREEN PRINTED STRING RIBBON SOLAR CELLS" 17TH. E.C. PHOTOVOLTAIC SOLAR ENERGY CONFERENCE. MUNICH, GERMANY, OCT. 22 - 26, 2001; [PROCEEDINGS OF THE INTERNATIONAL PHOTOVOLTAIC SOLAR ENERGY CONFERENCE], MUNICH : WIP-RENEWABLE ENERGIES, DE, vol. CONF. 17, 22 October 2001 (2001-10-22), pages 1719-1722, XP001139788 ISBN: 978-3-936338-08-9
- KAES M ET AL: "Bulk passivation in silicon ribbons: a lifetime study for an enhanced high efficiency process" PHOTOVOLTAIC SPECIALISTS CONFERENCE, 2005. CONFERENCE RECORD OF THE TH IRTY-FIRST IEEE LAKE BUENA VISTA, FL, USA 3-7 JAN. 2005, PISCATAWAY, NJ, USA,IEEE, US, 3 January 2005 (2005-01-03), pages 923-926, XP010822915 ISBN: 978-0-7803-8707-2
- SUREK T: "Crystal growth and materials research in photovoltaics: progress and challenges" JOURNAL OF CRYSTAL GROWTH, ELSEVIER, AMSTERDAM, NL, vol. 275, no. 1-2, 15 February 2005 (2005-02-15), pages 292-304, XP004823210 ISSN: 0022-0248

## Description

### FIELD OF THE INVENTION

The invention generally relates to ribbon crystals and, more particularly, the invention relates to grain boundaries of wafers formed from ribbon crystals.

### BACKGROUND OF THE INVENTION

String ribbon crystals, such as those discussed in U.S. Patent No. 4,689,109 (issued in 1987 and naming Emanuel M. Sachs as the sole inventor), can form the basis of a variety of electronic devices. For example, Evergreen Solar, Inc. of Marlborough, Massachusetts forms solar cells from conventional string ribbon crystals.

As discussed in greater detail in the noted patent, conventional processes form string ribbon crystals by passing two or more strings through molten silicon. Due to the nature of the process, a string ribbon crystal often grows with an irregular width. Consequently, rather than forming a smooth, generally planar shape, the long edges of the crystals often form an irregular shape. Accordingly, when processed into solar cells, their spacing typically is farther from adjacent wafers than if the edges were substantially smooth and planar, thus reducing the total power produced by the cells per unit area. Such a result is contrary to the goal of maximizing the power produced per unit area of a solar cell.

In addition, also as a result of this non-uniform growth, the portions near the edges of the crystals often form a high density of grains and, consequently, a high density of grain boundaries. As known by those in the art, grain boundaries generally reduce the electrical efficiency of the wafer by acting as "electron traps." Moreover, many in the art consider the small grains and irregular edges to be not aesthetically pleasing.

When used to form solar cells, the wafers often have backside electrodes to transmit electrons. Due to the fluctuating and relatively unknown shape of the edges, however, those in the art typically do not form the backside electrodes on much of the area of the wafer. Instead, those in the art typically form the backside electrode in a smaller area of the wafer; namely, spaced a relatively large distance from the edges of the wafer. Accordingly, this practice further reduces the full electrical efficiency of the wafer.

Hahn *et al.* (see Hahn et al. (2001), 17th E.C. Photovoltaic solar energy conference, Munich, Germany, Oct. 22-26, 2001; [Proceedings of the international photovoltaic solar energy conference] Munich: WIP-Renewable Energies, DE, Vol. Conf. 17,22 October 2001, pp. 1719-1722, ISBN: 978-3-936338-08-9) discloses 14% efficient large area screen printed string ribbon solar cells and discloses in this context edge isolation of string ribbon cells, wherein mainly the two sides containing the strings of a string ribbon crystal are subjected to a shunting mechanism (see Hahn *et al.,* p. 1719, title and abstract). The method for edge isolation in Hahn *et al.* (2001) may comprise laser groove at back side, laser groove at front side, sawing of all 4 sides, sawing of two short sides (no strings) and sawing of two long sides (strings).

Similarly, Kaes *et al.* (see Kaes et al., Photovoltaic specialist conference, Conference Record of the Thirty-First IEEE Lake Buena Vista, FL, USA, Jan. 2005, Piscataway, NJ, USA, IEEE, US, 3 January 2005, pp. 923-926, ISBN: 978-0-7803-8707-2) only discloses bulk passivation of ribbon silicon using a hydrogen rich PECVD SiN layer followed by firing instead of enhancing minority carrier diffusion lengths as compared to hydrogenation using MIRHP applied to the photolithography process (see Kaes *et al.* (2005), p. 926, right column, section "Summary"). Kaes *et al.* (2005) also shows processing of string ribbon wafers by laser sawing (see p. 923, right column, para. 2).

JP 62-108797 is a patent abstract from Japan and simply discloses the production of a strip crystal and a device therefore. In JP 62-108797 a carbon yam 8 is horizontally pulled up from a melt 2 (see JP 62-108797, English abstract). JP 62-108797 does not disclose removing of an upper edge.

Reverting to US 5,122,504, said document mentions preparation of a Bi-based superconducting source material using two parallel platinum support wires (see US 5,122,504, abstract).

Finally, EP 0 079 567 discloses a ribbon crystal but no string ribbon crystal. EP 0 079 567 only discloses a polycrystalline silicon sheet produced by applying silicon to the two principal surfaces of a sheet of carbon (see EP 0 079 567, p. 1, 11. 20 to 31).

None of these documents disclose that the plurality of large grains having smallest outer dimensions shall be greater than about two times the diffusion length of the carriers.

### SUMMARY OF THE INVENTION

In accordance with one embodiment of the invention, a method of processing a ribbon crystal provides a string ribbon crystal, and removes at least one edge of the string ribbon crystal, wherein the ribbon crystal includes a plurality of large grains, a plurality of small grains, and a plurality of carriers, the plurality of carriers having a diffusion length, the plurality of large grains having smallest outer dimensions that are greater than about two times the diffusion length of the carriers, removing comprising leaving the majority of large grains in the ribbon crystal and removing the majority of the small grains from the ribbon crystal.

The method also can remove the string with the edge, or remove the portion between the string and the edge. In addition, removal of the edge can form a substantially planar edge or non-planar edge on the crystal. The method also can remove two or more edges of the string ribbon crystal.

In addition to removing at least one edge, the method can separate the ribbon crystal into a plurality of individual wafers after removing at least one edge. After forming the wafers, the method can form a back-surface contact on at least one of the wafers. Alternatively, the method can first form a back-surface contact on the string ribbon crystal before removing at least one edge of the string ribbon crystal, and then separate the ribbon crystal into a plurality of individual wafers. In either case, removal of the original edge forms a new edge, and the back-surface contact may substantially extend to the new edge. In other embodiments, however, the back-surface contact is spaced from the new edge.

Among other ways, the ribbon crystal may be provided by growing the ribbon crystal from molten silicon (e.g., polysilicon). When providing the crystal while growing, removal of the edge may involve removing at least one edge as the ribbon crystal grows, or removing the edge after the ribbon crystal finishes growing.

The method preferably removes the edge of the ribbon crystal at a point that improves ultimate device performance. For example, if the ribbon crystal has a grain boundary, then the method may remove at least a portion of the grain boundary.

Various embodiments thus form a string ribbon wafer having a body with larger grains. The body also may be free of string on at least one side and have an edge that is substantially planar or, in some embodiments, has an irregular pattern and no string.

In accordance with another embodiment of the invention, a method of processing a ribbon crystal provides a string ribbon crystal, and then separates the crystal into a plurality of wafers. After separating the crystal, the method removes at least one edge of at least one of the plurality of wafers.

In accordance with another embodiment of the invention, a string ribbon wafer has a body with a plurality grains, which includes a plurality of large grains and a plurality of small grains. The plurality of large grains have smallest outer dimensions that are greater than about two times the diffusion length of the carriers within the wafer. The majority of the plurality of grains are large grains and the body is substantially free of string.

### BRIEF DESCRIPTION OF THE DRAWINGS

Those skilled in the art should more fully appreciate advantages of various embodiments of the invention from the following "Description of Illustrative Embodiments," discussed with reference to the drawings summarized immediately below.
Figure 1 schematically shows a partially cut-away view of a silicon ribbon crystal growth furnace that may participate in implementation of illustrative embodiments of the invention.
Figure 2 schematically shows an example of a string ribbon crystal without its edges removed.
Figure 3 schematically shows an example of the string ribbon crystal of Figure 2 with its edges removed.
Figure 4 shows a method of forming a wafer in accordance with illustrative embodiments of the invention.

### DESCRIPTION OF ILLUSTRATIVE EMBODIMENTS

In illustrative embodiments, a wafer fabrication method removes an edge of a string ribbon crystal, or an edge of a wafer cut from the string ribbon crystal, to substantially mitigate the above noted problems. Specifically, among other things, this method may both generally planarize the crystal/wafer edge and remove at least a portion of the smaller grains that act as electron traps. Accordingly, the resultant wafers 1) have improved electrical properties, 2) may be positioned in closer proximity to neighboring wafers, and 3) maximize the area of a back-surface contact. In addition, removal of the smaller grains should improve the aesthetic appearance to some observers. Details of illustrative embodiments are discussed below.

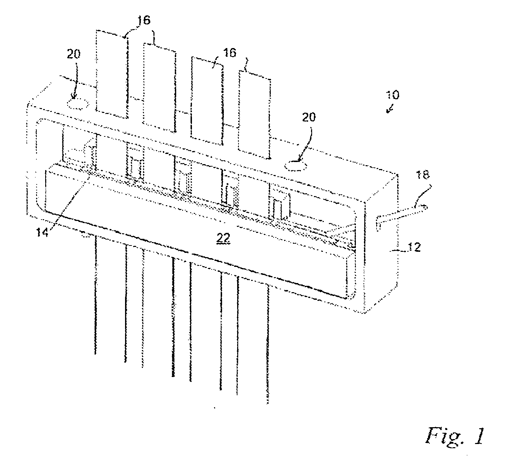

Figure 1 schematically shows a partially cut-away view of a silicon ribbon crystal growth furnace 10 that may implement illustrative embodiments of the invention. The furnace 10 has, among other things, a housing 12 forming a sealed interior that is substantially free of oxygen (to prevent combustion). Instead of oxygen, the interior has some concentration of another gas, such as argon, or a combination of gasses. The housing interior also contains, among other things, a crucible 14 and other components for substantially simultaneously growing four silicon ribbon crystals 16. The ribbon crystals 16 may be any of a wide variety of crystal types, such as multi-crystalline, single crystalline, polycrystalline, microcrystalline or semi-crystalline. A feed inlet 18 in the housing 12 provides a means for directing silicon feedstock to the interior crucible 14, while an optional window 16 permits inspection of the interior components.

It should be noted that discussion of silicon ribbon crystals 16 is illustrative and not intended to limit all embodiments of the invention. For example, the crystals 16 may be formed from a material other than silicon, or a combination of silicon and some other material.

An interior platform 20 within the housing 20 supports the crucible 14. This embodiment of the crucible 14 has an elongated shape with a region for growing silicon ribbon crystals 16 in a side-by-side arrangement along its length. In illustrative embodiments, the crucible 14 is formed from graphite and resistively heated to a temperature capable of maintaining silicon above its melting point. To improve results, the crucible 14 has a length that is much greater than its width. For example, the length of the crucible 14 may be three or more times greater than its width. Of course, in some embodiments, the crucible 14 is not elongated in this manner. For example, the crucible 14 may have a somewhat square shape, or a nonrectangular shape. String holes (not shown) through the crucible 14 enable strings to pass through molten silicon and thus, form the crystals 16.

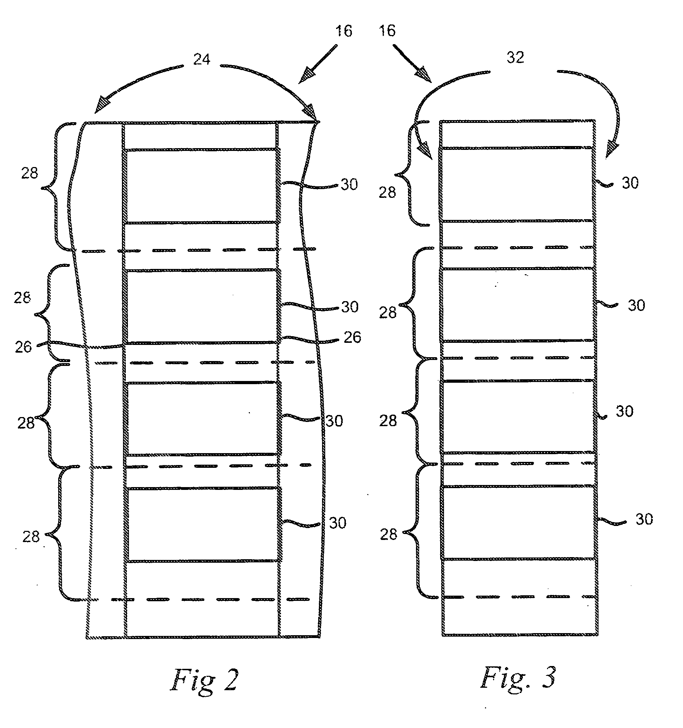

Figure 2 schematically shows an example of a string ribbon crystal 16 produced by the furnace 10 shown in Figure 1. This ribbon crystal 16 still has its original edges 24, which were formed as the crystal 16 was slowly drawn from the molten silicon in the crucible 14. As shown, the edges 24 of the ribbon crystal 16, which are not drawn to scale, are irregularly shaped. In some embodiments, however, the original edges 24 are not irregularly shaped. Instead, in such embodiments, the edges 24 are generally planar and generally parallel with the strings 26 (discussed immediately below) of the ribbon crystal 16.

Figure 2 also shows a pair of strings 26, which normally are encapsulated by the silicon. Although the drawing shows what appears to be a significant area between the strings 26 and their respective edges 24, it is anticipated that the strings 26 will be very close to their respective edges 24 and thus, effectively form the edges 24. Figure 2 also shows dashed lines identifying the boundary of wafers 28 ultimately to be produced. Conventional methods cut along the dashed lines to form each wafer 28. Each wafer 28 also has a back-surface contact 30. As its name suggests, the back-surface contacts 30 are formed on a side of the ribbon crystal 16 that ultimately will be the back surface of the wafers 28 (i.e., if used as a solar cell).

The inventor discovered that the edges 24 of prior art ribbon crystals reduced the mobility for carriers within wafers 28 ultimately formed from the ribbon crystal 16. As a consequence, when used in various applications requiring carrier mobility, such as solar cells, a prior art ribbon crystal would be less electrically efficient than it would be if it did not have such edges 24. To overcome this and other problems, the inventor took an approach that is contrary to what they understood to be the conventional wisdom - they removed at least a portion of the edge 24. As a result, the inventor removed many of the smaller grains, which produce a high concentration of grain boundaries. During subsequent tests, the inventor discovered that removal of the edges 24 improved the electrical efficiency in solar cells (e.g., carrier mobility), which is critical in the viability of photovoltaics.

Those in the art recognize significant disincentives associated with removing the edges. Among other things, removal of either edge 24 removes a significant amount of the polysilicon, which currently is in low supply and has a corresponding high cost. The inventor nevertheless was surprised to discover that resultant efficiency improvements more than offset the costs associated with material loss caused by edge removal.

In addition, removal of either edge 24 requires an additional process step or a plurality of additional steps, further increasing production costs. In fact, the additional steps/cuts required to perform this process increase the likelihood of crystal breakage, thus reducing yield. Moreover, the inventor believes that reducing the width of the ribbon crystal 16, and/or removing the string 26, can lead to additional breakage/yield problems. Despite these and other obstacles teaching away from their solution, the inventor removed the edges 24 to discover the improved benefits.

After removing the edge 24 (and string 26, in some cases), the remaining ribbon crystal 16 was left with mostly large grains. In particular, a grain is considered to be "large" when it has a smallest outer dimension that is greater than about two times the diffusion length of carriers (e.g., holes and electrons) within the crystal 16. For example, grains having a smallest outer dimension of between about 2-5 times the diffusion length of the carriers should suffice. Grains having smallest outer dimensions of greater than three times should provide even better results. In fact, it is anticipated that larger grain sizes, even five or more times the carrier diffusion length, should provide even better results.

Accordingly, in illustrative embodiments, the substantial majority of all grains remaining in the crystal 16 are large grains-leaving only trace amounts of small grains. Other embodiments, however, may have more than trace amounts of small grains. In either case, the removal step preferably removes a majority of the small grains, which generally concentrate around the string 26.

To that end, Figure 3 schematically shows the ribbon crystal 16 of Figure 2 with both of its edges 24 removed. As shown, the (new) edges (identified by reference number 32) of the ribbon crystal 16 are substantially planar. In alternative embodiments, however, the new edge 32 may be a non-planar shape, or irregularly shaped. In either case, the ribbon crystal 16 of Figure 3 has substantially no small grains or very few small grains when compared to the ribbon crystal 16 before the edge 24 is removed. In addition, the back-surface contacts 30 each extend to the new edge 32 of the ribbon crystal 16.

The ribbon crystals 16 in Figures 2 and 3 are illustrative of but one of a number of different embodiments. For example, the back-surface contact 30 may be added after the ribbons are separated/cut into individual wafers 28, and/or not extend to the new edge 32. As another example, only one edge 24 may be removed, and/or the edge 24 may be removed after the ribbon crystal 16 is separated/cut into individual wafers 28. Those skilled in the art may select the appropriate combinations of features based on the ultimate processing and application requirements and preferences.

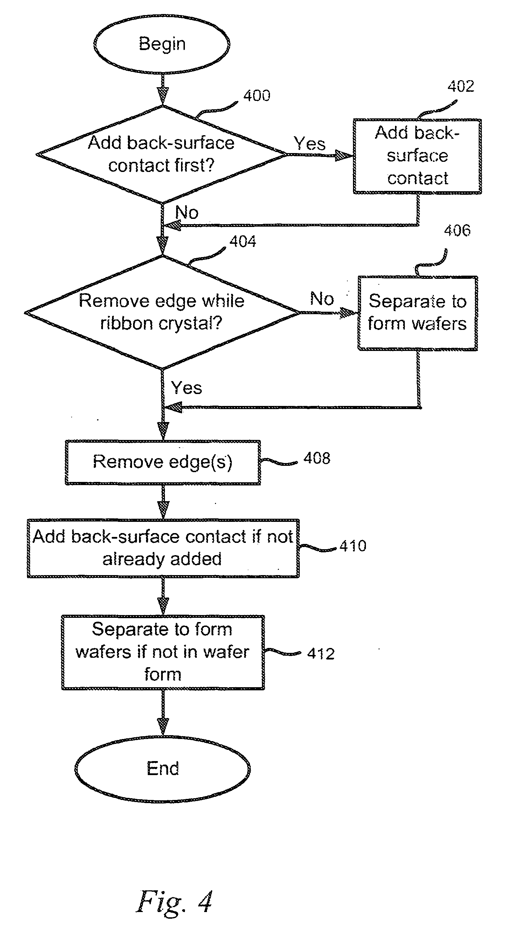

Figure 4 shows a method of forming a wafer 28 in accordance with illustrative embodiments of the invention. It should be noted that this method is a simplified summary of the overall process of forming a wafer 28 and thus, does not include a number of other steps that may be included, such as wafer testing and preparation of certain equipment and the silicon. Moreover, some steps may be performed in a different order or, in some instances, omitted.

For simplicity, this description omits a number of steps involving details of crystal growth from a molten material. However, those skilled in the art can refer to conventional string ribbon techniques as an adjunct to those discussed in Figure 4. Among other things, those skilled in the art can refer to details of co-pending US Patent Application No. 11/741,372 (US Patent Publication No. 2008/0134964) and co-pending US Patent Application No.11/925,169 (US Patent Publication No. 2008/0102605) for additional information. Both of these published applications are incorporated herein, in their entireties, by reference. Those skilled in the art also may refer to various processes used by Evergreen Solar, Inc. of Marlboro, MA to further implement various embodiments. The steps of Figure 4 can be integrated with the processes discussed in the incorporated patent applications, or other conventional string ribbon crystal formation processes.

It also should be noted that discussion of this method of Figure 4 is not intended to be construed as the only method of forming a wafer 28 to have the desired properties. Those skilled in the art thus may modify the process as necessary.

The method begins while a ribbon crystal growth furnace 10 draws a ribbon crystal 16 from a molten material. Specifically, at step 400, the method determines if the back-surface contact 30 is to be added to the ribbon crystal 16 before or after removing one or both of the edges 24 (for simplicity, this method refers to one or both edges 24 in the singular; as an "edge 24"). In some instances, if it is formed after removing the edge 24, the back-surface contact 30 undesirably may extend around the new edge 32, which could cause a short circuit. Consideration of this possibility therefore should be used in making this determination.

If step 400 determines that the back-surface contact 30 is to be formed first, then the method continues to step 402, which adds the back-surface contact 30 to the ribbon crystal 16. Among other ways, conventional processes may screen print the back-surface contact 30 on one side of the ribbon crystal 16. For example, the back-surface contact 30 may be screen printed onto the ribbon crystal 16 as a plurality of separate blocks, as shown in Figures 2 and 3, or as a solid block spanning more than one wafer 28.

After completing step 402, or, if at step 400 the back-surface contact 30 is not to be formed on the ribbon crystal 16 before the edge 24 is removed, then the method determines at step 404 if the edge(s) 24 should be removed while in the form of a ribbon crystal. In other words, the method may remove the edge(s) 24 either before or after the ribbon crystal 16 is separated into individual wafers 28.

If the edge 24 is not to be removed while in the ribbon crystal state/form, then the method separates the ribbon crystal 16 along the dashed lines of Figure 2 to form individual wafers 28 (step 406). To that end, the conventional sawing or dicing processes may cut the ribbon along the dashed lines shown in Figures 2 and 3. For example, a laser may cut along the dashed lines as discussed in the above incorporated patent application.

The method then continues to step 408, which removes one or both edges 24 of the ribbon crystal 16 (if continuing from step 404) or the wafers 28 (if continuing from step 406). To that end, when removing a given edge 24, conventional sawing/dicing processes may remove the entire string 26 and many other smaller grains inward of the string (if any). Experimental processes may determine how far to remove the edge 24 inward of the string 26.

It is anticipated that in some instances, however, the removal device (e.g., a laser or saw) may cut along a straight line, while the string 26 may not be positioned perfectly straight from top to bottom of the crystal 16. In a corresponding manner, the string may be more straight than the cut. As a result, the removal step may leave a portion of the string 26 behind in the crystal 16. To avoid this, if desired, one skilled in the art can select an appropriate distance to cut the ribbon crystal 16 (or wafer 28, as the case may be) inward from the string.

Alternatively, in a variety of embodiments, one skilled in the art can set the width of the crystal 16 and measure outwardly from a generally longitudinal point of the crystal 16. For example, to yield a crystal 16 with about a 100 millimeter width, one skilled in the art can cut along generally parallel lines about 50 millimeters from a general longitudinal portion of the crystal 16.

If the ribbon crystal 16 is grown to have a significant amount of area outward of the string 26, then some embodiments may remove a portion of the crystal 16 outward of the string 26, thus keeping the string 26 in the crystal 16. It nevertheless is anticipated that removal of the string 26 in such a crystal 16 will yield more efficient wafers. It should be noted that a wafer produced by the discussed techniques and in the described manners is considered to be a string ribbon wafer even if the string 26 is partially or completely removed.

The method may perform step 408 in a number of different manners. Specifically, if removing the edge(s) 24 while in ribbon crystal form, the method may automate the process as the ribbon crystal 16 grows. For example, the furnace 10 may be retrofitted to include a saw or laser (not shown) to remove the edge(s) 24 from the growing ribbon crystal 16 in real time. Alternatively, the ribbon crystal 16 first may be manually scribed to remove it from the furnace 10, and then manually or automatically moved to another machine that cuts the edge(s) 24 in the prescribed manner. Of course, some embodiments remove the edge(s) 24 by means of an operator manually scribing the edge(s) 24 of the ribbon crystal 16. In a similar manner, if already in wafer form, then the method may use either automatic or manual means to remove the edge(s) 24.

Accordingly, removal of one or both edges 24 removes the smaller grains (i.e., the area with high grain density). This should leave relatively larger grains in the resulting wafers 28, which improves electrical efficiency.

The method concludes by adding the back-surface contact 30 to the ribbon crystal 16 or wafers 28, depending on their form, if such feature was not already added (step 410), and separating the ribbon crystal 16 into wafers 28 if not already in that form (step 412).

It should be noted that the back-surface contact 30 may be formed at a number of different points in the overall fabrication of a solar cell. For example, the method could add the back-surface contact 30 before any fabrication steps are executed, or add the back-surface contact 30 after performing a number of solar cell fabrication steps that were not discussed.

Accordingly, illustrative embodiments produce wafers 28 having substantially planar edges 32 with few or no grain boundary regions. These planar edges 32 may form approximately ninety degree angles with their adjacent sides (i.e., the intersection of the top edge and the new side edge 32 of the ultimate wafers 28). Alternatively, or in addition, these planar edges 32 may form acute and/or obtuse angles with their adjacent sides. Moreover, such embodiments may form new edges 32 having a variety of shapes (e.g., irregularly shaped).

Consequently, as noted above, in addition to improving the aesthetic appearance to some observers, many such wafers 28 should 1) have improved electrical properties due to removal of many of the high grain concentrations near the crystal edge, 2) may be positioned in closer proximity to neighboring wafers, and 3) maximize the area of a back-surface contact 30.

Although the above discussion discloses various exemplary embodiments of the invention, it should be apparent that those skilled in the art can make various modifications that will achieve some of the advantages of the invention without departing from the true scope of the invention.

## Claims

1. A method of processing a ribbon crystal, the method comprising:
providing a string ribbon crystal, and
removing at least one edge of the string ribbon crystal, wherein the ribbon crystal includes a plurality of large grains, a plurality of small grains, and a plurality of carriers, the plurality of carriers having a diffusion length, the plurality of large grains having smallest outer dimensions that are greater than about two times the diffusion length of the carriers, removing comprising leaving the majority of large grains in the ribbon crystal and removing the majority of the small grains from the ribbon crystal.

2. The method as defined by claim 1, wherein the at least one edge comprises a string, removing comprising removing most of the string of the one edge.

3. The method as defined by claim 1 or 2, further comprising:
separating the ribbon crystal into a plurality of individual wafers after removing at least one edge of the string ribbon crystal.

4. The method as defined by claim 3, further comprising:
forming a back-surface contact on the string ribbon crystal before removing at least one edge of the string ribbon crystal,
separating the ribbon crystal into a plurality of individual wafers after forming the back-surface contact.

5. The method as defined by claim 3, further comprising:
forming a back-surface contact on at least one of the wafers, wherein removing forms a new edge, the back-surface contact substantially extending to the new edge.

6. The method as defined by claim 3, further comprising:
forming a back-surface contact on at least one of the wafers, wherein removing forms a new edge, the back-surface contact being spaced from the new edge.

7. The method as defined by claim 1 or 2, wherein providing comprises growing the ribbon crystal from molten silicon, removing comprising removing the at least one edge as the ribbon crystal grows.

8. The method as defined by claim 1 or 2, wherein providing comprises growing the ribbon crystal from molten silicon, removing comprising removing the at least one edge after the ribbon crystal finishes growing.

9. The method as defined by claim 1, wherein the at least one edge comprises a string, removing comprising removing substantially all of the string of the one edge.

10. A string ribbon wafer comprising:
a body includes a plurality grains comprising a plurality of large grains and a plurality of small grains,
the body also having a plurality of carriers having a diffusion length,
the plurality of large grains having smallest outer dimensions that are greater than about two times the diffusion length of the carriers,
the majority of the plurality of grains being large grains,
the body being substantially free of string.

11. The string ribbon wafer as defined by claim 10, wherein a plurality of the large grains have an outer dimension of between about 2-5 times the diffusion length of the carriers.

12. The string ribbon wafer as defined by claim 10 or 11, wherein the body comprises an edge that is substantially planar.

13. The string ribbon wafer as defined by claim 10 or 11, wherein the body comprises an edge that has an irregular pattern.

14. String ribbon crystal obtainable by the method of claim 1, wherein the ribbon crystal includes a plurality of large grains, a plurality of small grains, and a plurality of carriers, the plurality of carriers having a diffusion length, the plurality of large grains having smallest outer dimensions that are greater than about two times the diffusion length of the carriers, removing comprising leaving the majority of large grains in the ribbon crystal and removing the majority of the small grains from the ribbon crystal.

## Patentansprüche

1. Verfahren zur Bearbeitung eines Ribbon-Kristalls (Bandkristall), wobei das Verfahren die Schritte umfasst:
Bereitstellung eines String-Ribbon-Kristalls, und Entfernung mindestens einer Ecke des String-Ribbon-Kristalls, wobei der Ribbon-Kristall eine Vielzahl von großen Körnern, eine Vielzahl von kleinen Körnern und eine Vielzahl von Trägern aufweist, wobei die Vielzahl von Trägern eine Diffusions-Länge aufweisen, und die Vielzahl von großen Körnern kleinste äußere Abmessungen aufweisen, die mehr als zweimal so groß sind wie die Diffusionslänge der Träger, wobei das Entfernen den Verbleib des Großteils der großen Körner im Ribbon-Kristall und die Entfernung des Großteils der kleinen Körner vom Ribbon-Kristall umfasst.

2. Das Verfahren gemäß Anspruch 1, wobei die mindestens eine Ecke einen String (Strang) umfasst, und das Entfernen das Entfernen des größten Teils des Strings der einen Ecke umfasst.

3. Das Verfahren gemäß Anspruch 1 oder 2, weiterhin umfassend:
Auftrennen des Ribbon-Kristalls in eine Vielzahl von individuellen Wafern nach Entfernen mindestens einer Ecke des String-Ribbon-Kristalls.

4. Das Verfahren gemäß Anspruch 3, weiterhin umfassend:
Ausbildung eines Kontakts auf der rückseitigen Fläche des String-Ribbon-Kristalls vor Entfernung mindestens einer Ecke des String-Ribbon-Kristalls,
Auftrennung des Ribbon-Kristalls in eine Vielzahl von individuellen Wafern nach Ausbildung des Kontakts auf der rückseitigen Fläche.

5. Das Verfahren gemäß Anspruch 3, weiterhin umfassend:
Ausbildung eines Kontakts auf der rückseitigen Fläche auf mindestens einem der Wafer, wobei das Entfernen eine neue Ecke ausbildet, und der Kontakt auf der rückseitigen Fläche sich im Wesentlichen zur neuen Ecke ausdehnt.

6. Das Verfahren gemäß Anspruch 3, weiterhin umfassend:
Ausbildung eines Kontakts auf der rückseitigen Fläche auf mindestens einem der Wafer, wobei das Entfernen eine neue Ecke ausbildet, und der Kontakt auf der rückseitigen Fläche von der neuen Ecke entfernt liegt.

7. Das Verfahren gemäß Anspruch 1 oder 2, wobei die Bereitstellung das Wachsen des Ribbon-Kristalls aus geschmolzenem Silizium umfasst, und das Entfernen das Entfernen der mindestens einen Ecke umfasst, wenn der Ribbon-Kristall wächst.

8. Das Verfahren gemäß Anspruch 1 oder 2, wobei das Bereitstellen das Wachsen des Ribbon-Kristalls aus geschmolzenem Silizium umfasst, und das Entfernen das Entfernen der mindestens einen Ecke umfasst, nachdem der Ribbon-Kristall das Wachstum beendet hat.

9. Das Verfahren gemäß Anspruch 1, wobei die mindestens eine Ecke einen String (Strang) umfasst, und das Entfernen das Entfernen im Wesentlichen aller Strings (Stränge) der einen Ecke umfasst.

10. Ein String-Ribbon-Wafer, umfassend:
einen Körper, der eine Vielzahl von Körnern aufweist, die eine Vielzahl von großen Körnern und eine Vielzahl von kleinen Körnern umfasst,
wobei der Körper ebenfalls eine Vielzahl von Trägern mit einer Diffusionslänge aufweist,
die Vielzahl von großen Körnern kleinste äußere Abmessungen aufweisen, die mehr als zweimal so groß sind wie die Diffusionslänge der Träger,
der Großteil der Vielzahl von Körnern große Körner sind, und
der Körper im Wesentlichen frei von Strings (Strängen) ist.

11. Der String-Ribbon-Wafer gemäß Anspruch 10, wobei eine Vielzahl der großen Körner eine äußere Abmessung zwischen etwa 2-5-mal der Diffusionslänge der Träger aufweisen.

12. Der String-Ribbon-Wafer gemäß Anspruch 10 oder 11, wobei der Körper eine im Wesentlichen planare Ecke aufweist.

13. Der String-Ribbon-Wafer gemäß Anspruch 10 oder 11, wobei der Körper eine Ecke mit einem unregulären Muster aufweist.

14. String-Ribbon-Kristall erhältlich durch ein Verfahren gemäß Anspruch 1, wobei der Ribbon-Kristall eine Vielzahl von großen Körnern, eine Vielzahl von kleinen Körnern und eine Vielzahl von Trägern aufweist, wobei die Vielzahl von Trägern eine Diffusionslänge aufweisen, die Vielzahl von großen Körnern kleinste äußere Abmessungen aufweisen, die größer sind als etwa das zweifache der Diffusionslänge der Träger, und das Entfernen den Verbleib des Großteils der großen Körner im Ribbon-Kristall und das Entfernen des Großteils der kleinen Körner vom Ribbon-Kristall umfasst.

## Revendications

1. Procédé de traitement d'un cristal en ruban, le procédé comprenant :
de fournir un cristal en ruban à cordon, et
d'enlever au moins un bord du cristal en ruban à cordon, dans lequel le cristal en ruban inclut une pluralité de gros grains, une pluralité de petits grains, et une pluralité de supports, la pluralité de supports ayant une longueur de diffusion, la pluralité de gros grains ayant des dimensions extérieures les plus petites qui sont plus grandes qu'environ deux fois la longueur de diffusion des supports, le fait d'enlever comprenant de laisser la majorité des gros grains dans le cristal en ruban et d'enlever la majorité des petits grains du cristal en ruban.

2. Procédé selon la revendication 1, dans lequel l'au moins un bord comprend un cordon, le fait d'enlever comprenant d'enlever la plupart du cordon du bord.

3. Procédé selon la revendication 1 ou 2, comprenant en outre :
de séparer le cristal en ruban en une pluralité de tranches individuelles après avoir enlevé au moins un bord du cristal en ruban à cordon.

4. Procédé selon la revendication 3, comprenant en outre :
de former un contact de surface de dos sur le cristal en ruban à cordon avant d'enlever au moins un bord du cristal en ruban à cordon,
de séparer le cristal en ruban en une pluralité de tranches individuelles après avoir formé le contact de surface de dos.

5. Procédé selon la revendication 3, comprenant en outre :
de former un contact de surface de dos sur au moins une des tranches, dans lequel le fait d'enlever forme un nouveau bord, le contact de surface de dos s'étendant sensiblement jusqu'au nouveau bord.

6. Procédé selon la revendication 3, comprenant en outre :
de former un contact de surface de dos sur au moins une des tranches, dans lequel le fait d'enlever forme un nouveau bord, le contact de surface de dos étant espacé du nouveau bord.

7. Procédé selon la revendication 1 ou 2, dans lequel le fait de fournir comprend de faire croître le cristal en ruban à partir de silicium fondu, le fait d'enlever comprend d'enlever l'au moins un bord quand le cristal en ruban croît.

8. Procédé selon la revendication 1 ou 2, dans lequel le fait de fournir comprend de faire croître le cristal en ruban à partir de silicium fondu, le fait d'enlever comprenant d'enlever l'au moins un bord après que le cristal en ruban a fini de croître.

9. Procédé selon la revendication 1, dans lequel l'au moins un bord comprend un cordon, le fait d'enlever comprenant d'enlever sensiblement tout le cordon du bord.

10. Tranche de ruban à cordon comprenant :
un corps qui inclut une pluralité de grains comprenant une pluralité de gros grains et une pluralité de petits grains,
le corps ayant aussi une pluralité de supports ayant une longueur de diffusion,
la pluralité de gros grains ayant des dimensions extérieures les plus petites qui sont plus grandes qu'environ deux fois la longueur de diffusion des supports,
la majorité de la pluralité de grains étant des gros grains,
le corps étant sensiblement sans cordon.

11. Tranche de ruban à cordon selon la revendication 10, dans laquelle une pluralité des gros grains ont une dimension extérieure d'entre environ 2-5 fois la longueur de diffusion des supports.

12. Tranche de ruban à cordon selon la revendication 10 ou 11, dans laquelle le corps comprend un bord qui est sensiblement plan.

13. Tranche de ruban à cordon selon la revendication 10 ou 11, dans laquelle le corps comprend un bord qui a un motif irrégulier.

14. Cristal en ruban à cordon pouvant être obtenu par le procédé selon la revendication 1, dans lequel le cristal en ruban inclut une pluralité de gros grains, une pluralité de petits grains, et une pluralité de supports, la pluralité de supports ayant une longueur de diffusion, la pluralité de gros grains ayant des dimensions extérieures les plus petites qui sont plus grandes qu'environ deux fois la longueur de diffusion des supports, le fait d'enlever comprenant de laisser la majorité des gros grains dans le cristal en ruban et d'enlever la majorité des petits grains du cristal en ruban.
